# EUROPEAN PATENT APPLICATION

(11) **EP 1 109 231 A2**
(43) Date of publication of application: **20.06.2001**
(21) Application number: 00127465.3
(22) Date of filing: 14.12.2000
(51) Int. Cl.: H01L 33/00, H01S 5/343

(54) **Semiconductor light emitter and method for fabricating the same**

(30) Priority: 15.12.1999 JP 35543599
(71) Applicant: Matsushita Electronics Corporation, Takatsuki-shi, Osaka 569-1193 (JP)
(72) Inventor: Yuri, Masaaki, Ibaraki-shi, Osaka 567-0828 (JP)
(74) Representative: Grünecker, Kinkeldey, Stockmair & Schwanhäusser Anwaltssozietät

(57) **Abstract**

A semiconductor light emitter includes: a first semiconductor layer formed over a substrate; a second semiconductor layer formed over the first layer; and a third semiconductor layer formed over the second layer. Bandgaps of the first and third layers are greater than a bandgap of the second layer. A high-quantum-level region is defined around an edge of the second layer. A first quantum level is higher in the high-quantum-level region than in the other region of the second layer.

## Description

### BACKGROUND OF THE INVENTION

The present invention relates to a semiconductor light emitter with a quantum well structure like a semiconductor laser diode or light-emitting diode.

In recent years, research and development has been vigorously carried on to realize a quantum well device with a novel function by making the bandgap in part of the active layer of a semiconductor light emitter different from the remaining part thereof. The bandgap can be made different by changing the thickness or composition of a selected part of the active layer.

For example, currently available red-light-emitting semiconductor laser diodes should have their catastrophic optical damage (COD) minimized to obtain as high an optical output power as 30 mW or more. Thus, the technique of controlling the bandgap within a plane of the active layer is applied thereto for that purpose. As used herein, the COD refers to a phenomenon by which the crystallinity of an emitter rapidly deteriorates at its facets when the emitter increases its optical output power. This phenomenon is caused because the radiation with that high power is absorbed into the emitter around the facets and the crystals, making up the facets, are molten due to the heat generated.

To avoid this COD phenomenon, a semiconductor laser diode with a so-called "facet window structure" was proposed as disclosed in Japanese Laid-Open Publication No. 58-500681. According to this technique, the light-emitting facets are intentionally disordered by diffusing the dopant introduced so that the quantum well structure will have its bandgap increased around the facets. This technique will be herein called a "first prior art example" for convenience sake.

Also, another method of preventing the radiation, emitted from the active layer of a semiconductor laser diode, from being absorbed into the diode around its facets was disclosed in Japanese Laid-Open Publication No. 6-21568. According to this technique, portions of the active layer near the light-emitting facets are removed and a semiconductor layer, having a bandgap greater than that of the active layer, is formed instead in those portions. This technique will be herein called a "second prior art example" for convenience sake.

Hereinafter, a semiconductor laser diode according to the first prior art example will be described with reference to the accompanying drawings.

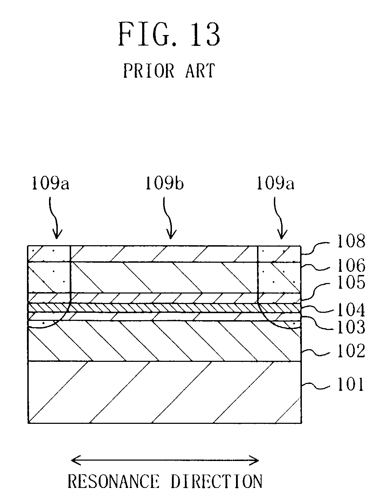

FIG. **13** illustrates a cross-sectional structure of the resonant cavity of a known semiconductor laser diode with the "facet window structure". The cross section illustrated in FIG. **13** is taken in the direction in which resonance occurs in the resonant cavity (which will be herein called a "resonance direction").

As shown in FIG. **13**, first cladding layer **102**, first optical guide layer **103**, active layer **104**, second optical guide layer **105**, second cladding layer **106,** current blocking layer (not shown) and contact layer **108** are stacked in this order on an n-GaAs substrate **101**. The first cladding layer **102** is made of n-Al_{0.5}Ga_{0.5}As and has a thickness of 1.5µm. The first optical guide layer **103** is made of undoped Al_{0.3}Ga_{0.7}As and has a thickness of 20 nm. The active layer **104** is made of undoped Al_{0.1}Ga_{0.9}As and has a thickness of 9 nm. The second optical guide layer **105** is made of undoped Al_{0.3}Ga_{0.7}As and has a thickness of 20 nm. The second cladding layer **106** is made of p-Al_{0.5}Ga_{0.5}As and includes a waveguide with ridges extending in the resonance direction. The thickness of the second cladding layer **106** at the top of the ridges is 1.5µm, while the thickness thereof at the bottom of the ridges is 0.15µm. The current blocking layer is made of n-GaAs and has a thickness of 1.35µm. And the contact layer **108** is made of p-GaAs and has a thickness of 2µm.

Around the facets of the resonant cavity, zinc (Zn) diffused regions **109a**, extending from the contact layer **108** through the active layer **104**, are defined by thermally diffusing Zn. In the following description, a region **109b** located between the Zn-diffused regions **109a** will be referred to as a non-Zn-diffused region **109b**.

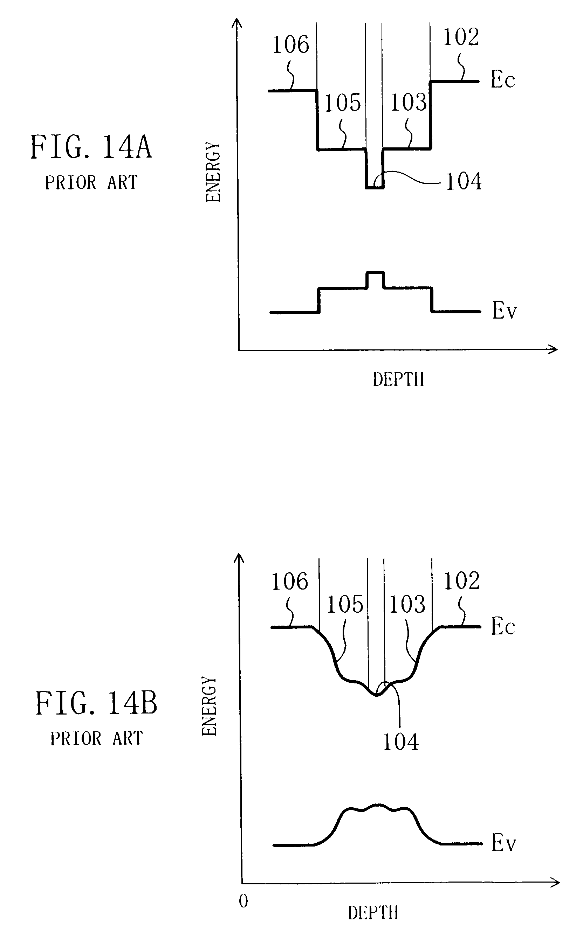

FIGS. **14A** and **14B** illustrate the distributions of bandgaps in the non-Zn-diffused region **109b** and Zn-diffused regions **109a** in the depth direction, respectively.

As shown in FIG. **14B**, the Al mole fraction of the active layer **104**, which was 0.1 originally, increases in the Zn-diffused regions **109a**, because interdiffusion is caused between the Zn atoms diffused and Ga or Al atoms. Accordingly, in the Zn-diffused regions **109a**, the wavelength at the peak of absorption becomes shorter than the oscillation wavelength of the laser diode, which is determined by the active layer in the non-Zn-diffused region **109b**. As a result, the Zn-diffused regions **109a** become substantially transparent to the radiation with the oscillation wavelength, and the amount of light absorbed into the facets of the resonant cavity can be reduced.

In the semiconductor laser diode of the second prior art example, recombined radiation, created in the active layer, is guided to the optical guide layers and then emitted from the facets. In this case, the active layer, including the facets, is entirely covered with the first cladding layer and is not exposed. Accordingly, the COD is unlikely to be caused at the facets of the resonant cavity.

However, the semiconductor laser diode of the first prior art example has the following drawbacks.

Firstly, the crystals in the active layer **104** and the first and second optical guide layers **103** and **105** are intentionally disordered in the laser diode. Accordingly, the active layer **104** has its crystallinity deteriorated and is more likely to cause crystal imperfections, thus decreasing the reliability of the laser diode.

Secondly, the diffused Zn atoms remain interstitially among the atoms of semiconductor crystals that make up the active layer **104**. Accordingly, if the laser diode is operated for a long time, then the temperature of the diode goes on rising to further diffuse the Zn atoms. As a result, the performance of the laser diode noticeably deteriorates with time.

Thirdly, if Zn is doped at a high level, then the active layer **104** itself absorbs a greater number of free carriers more easily. Consequently, the threshold current rises and the slope efficiency (which is a variation in optical output power against operating current) decreases.

In the semiconductor laser diode of the second prior art example, the active layer has been partially removed around the facets to form steps, on which the first cladding layer is formed through re-growth. Accordingly, the active layer might be damaged or the crystallinity might deteriorate around the interface between the active layer and the first cladding layer (particularly in an interface around the facets from which the laser radiation is emitted). As a result, the laser diode might have its reliability degraded. Furthermore, a degraded layer might be formed around the interface. In that case, the laser radiation is unintentionally absorbed into the facets and their surrounding regions to cause the COD phenomenon in the end.

### SUMMARY OF THE INVENTION

An object of the invention is suppressing the COD and deterioration in performance of a semiconductor light emitter with time by minimizing the degradation in crystallinity of the active layer and by considerably reducing the amount of light absorbed in the facets of the resonant cavity and surrounding regions.

To achieve this object, according to the present invention, the quantum energy level is set higher around the facets of the resonant cavity of a semiconductor light emitter than in the other region thereof.

Specifically, a first inventive semiconductor light emitter includes: a first semiconductor layer formed over a substrate; a second semiconductor layer formed over the first layer; and a third semiconductor layer formed over the second layer. Bandgaps of the first and third layers are greater than a bandgap of the second layer. A high-quantum-level region is defined around an edge of the second layer. In the high-quantum-level region, the first quantum level is higher than in the other region of the second layer.

In the first inventive light emitter, the bandgaps of the first and third layers are greater than that of the second layer. In addition, a high-quantum-level region is defined around an edge of the second layer. In the high-quantum-level region, the first quantum level is higher than in the other region of the second layer. Accordingly, an absorption coefficient considerably decreases at the edges of the second layer and the radiation emitted from the second layer is much less likely to be absorbed into the edges. As a result, the COD phenomenon can be suppressed and the deterioration in performance of the laser diode with time can be minimized.

In one embodiment of the present invention, parts of the first or third layer, which are located near the edges of the second layer, preferably have a bandgap greater than the other part of the first or third layer. In such an embodiment, the first quantum level can be increased just as intended at the edges of the second layer interposed between the first and third layers.

In another embodiment of the present invention, the first layer preferably has a pair of facets that extend substantially vertically to the principal surface of the substrate and that face each other, and at least one of these facets is preferably located in the high-quantum-level region. In such an embodiment, if the pair of facets is used as the facets of the resonant cavity, then the COD can be suppressed at the facets of the resonant cavity just as intended.

In still another embodiment, each said high-quantum-level region is preferably defined to extend from an associated facet of the second layer inward over a predetermined distance. Then, the second layer can create radiation at a desired wavelength.

In yet another embodiment, the first or third layer preferably has a thickness of 0.5 nm through 20 nm.

In yet another embodiment, the first or third layer is preferably made of a semiconductor that reacts with oxygen atoms more easily than the second layer does. And oxygen atoms have preferably been introduced into edges of the first or third layer to a level higher than the other part of the first or third layer so that a bandgap at the edges of the first or third layer is greater than that in the other part of the first or third layer. In such an embodiment, the first quantum level can be increased just as intended at the edges of the second layer interposed between the first and third layers. In addition, the second layer is much less likely to be affected by the oxygen atoms introduced.

In yet another embodiment, the first and third layers may be made of AlGaAs, and the second layer may be made of: AlGaAs that has an Al mole fraction smaller than that of AlGaAs for the first and third layers; InGaAs; or GaAs.

In an alternative embodiment, the first and third layers may be made of AlGaInP, and the second layer may be made of: AlGaInP that has an Al mole fraction smaller than that of AlGaInP for the first and third layers; InGaP; or GaAs.

Whether the first and third layers are made of AlGaAs or AlGaInP, the Al mole fraction in the second layer is preferably 0.3 or less.

As another alternative, the first and third layers may be made of BₓAl_{y}Ga_{1-x-y-z}In_{z}N, where 0≦x≦1, 0≦y≦1, 0≦z≦I and 0 ≦x+y+z≦1, and the second layer may be made of: BₓAl_{y}Ga_{1-x-y-} _{z}In_{z}N, where 0≦x≦1, 0≦y≦1, 0≦z≦1 and 0≦x+y+z≦1 and which has an Al mole fraction smaller than that of BₓAl_{y}Ga_{1-x-y-z}In_{z}N for the first and third layers; InGaN; or GaN.

A second inventive semiconductor light emitter includes: a first semiconductor layer formed over a substrate; a second semiconductor layer formed over the first layer; and a third semiconductor layer formed over the second layer. The first or third layer has a bandgap greater than that of the second layer and is made of a semiconductor that reacts with oxygen atoms more easily than the second layer does. And oxygen atoms have been introduced into edges of the first or third layer to a level higher than the other part of the first or third layer so that a bandgap at the edges of the first or third layer is greater than that in the other part of the first or third layer.

In the second semiconductor light emitter, where the second layer has a quantum well structure, the first quantum level increases at the edges of the second layer interposed between the first and third layers. Accordingly, if the edges of the second layer are used as the facets of the resonant cavity, the absorption coefficient considerably decreases at the facets and the emission from the second layer is much less likely to be absorbed into the facets. As a result, the COD can be suppressed and the deterioration in performance of the light emitter with time can be minimized.

Furthermore, the second layer is not easily affected by the oxygen atoms introduced and the edges of the first or third layer have been oxidized. Accordingly, current injected does not flow easily through the edges of the second layer. That is to say, the current injected is concentrated to the center of the second layer. As a result, where the light emitter is a surface-emitting laser diode, the resultant luminous efficacy increases greatly.

In one embodiment of the present invention, the second layer preferably includes a quantum well layer.

An inventive method for fabricating a semiconductor light emitter includes the steps of: a) stacking first, second and third semiconductor layers in this order over a substrate to obtain a multilayer structure including the first, second and third layers; and b) exposing at least one side face of the multilayer structure to an ambient containing oxygen atoms, thereby oxidizing a side face of the first or second layer.

According to the inventive method, the first or second inventive semiconductor light emitter can be fabricated just as originally designed without damaging the second semiconductor layer (that will be an active layer) at all.

In one embodiment of the present invention, the first and third layers preferably have a bandgap greater than that of the second layer.

In another embodiment of the present invention, the first or third layer is preferably made of a semiconductor that reacts with oxygen atoms more easily than the second layer does.

In still another embodiment, the step a) preferably includes the step of forming a quantum well layer in the second layer.

In yet another embodiment, the step b) preferably includes an annealing process in which water vapor is used as the ambient.

### BRIEF DESCRIPTION OF THE DRAWINGS

FIG. 1 is a cross-sectional view, taken in the resonance direction, illustrating a structure for a semiconductor laser diode according to a first embodiment of the present invention.

FIGS. **2A** and **2B** are band diagrams illustrating energy levels around a quantum well active layer of the semiconductor laser diode of the first embodiment:

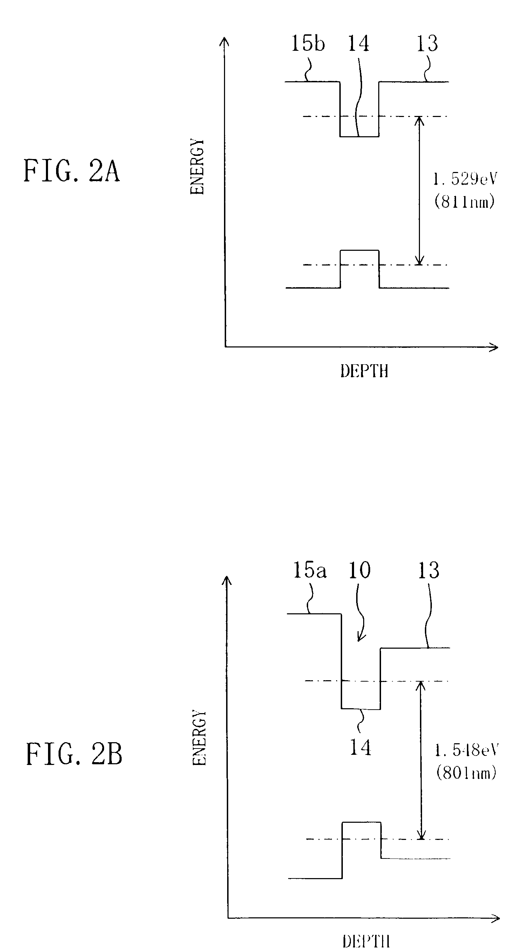

FIG. **2A** illustrates energy levels for part of the laser diode including a part with a low Al mole fraction; and
FIG. **2B** illustrates energy levels for another part of the laser diode including a part with a high Al mole fraction.

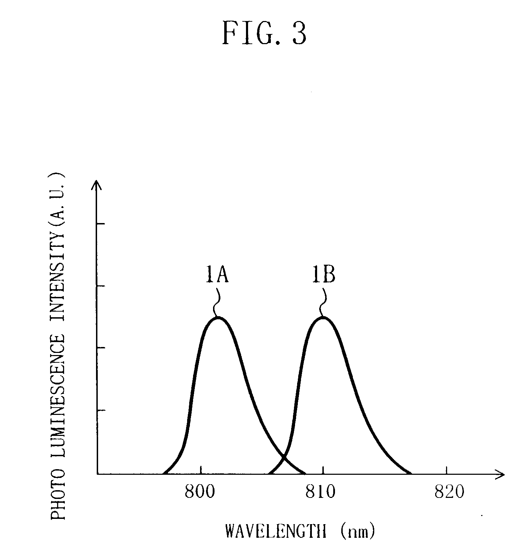

FIG. **3** is a graph illustrating the spectra of radiation emitted from those parts with high and low Al fractions, respectively, of the quantum well active layer in the laser diode of the first embodiment.

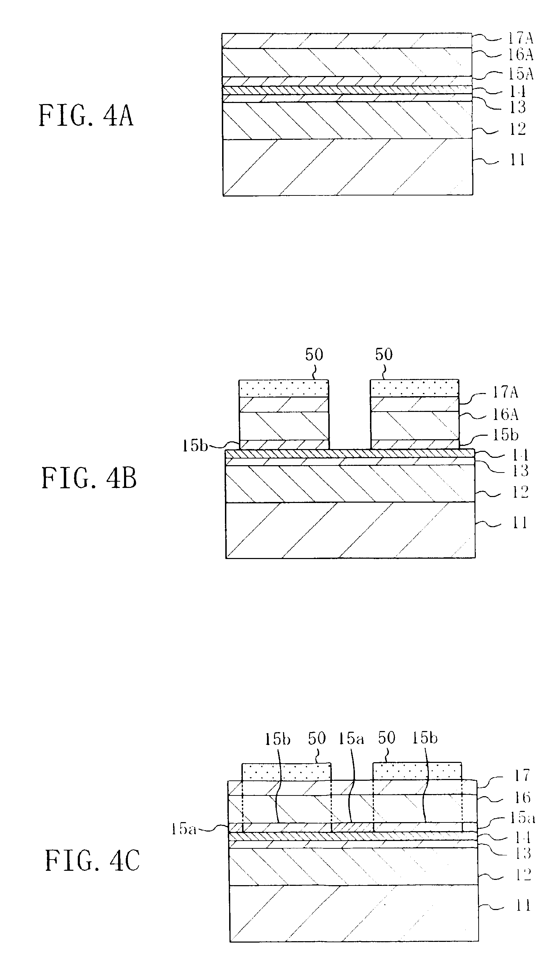

FIGS. **4A** through **4C** are cross-sectional views illustrating respective process steps for fabricating the semiconductor laser diode of the first embodiment.

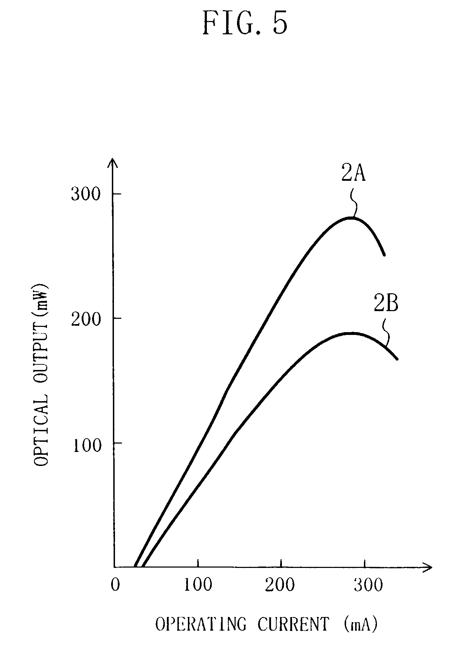

FIG. **5** is a graph illustrating the current-optical output power characteristics of semiconductor laser diodes according to the first embodiment and the first prior art example in comparison.

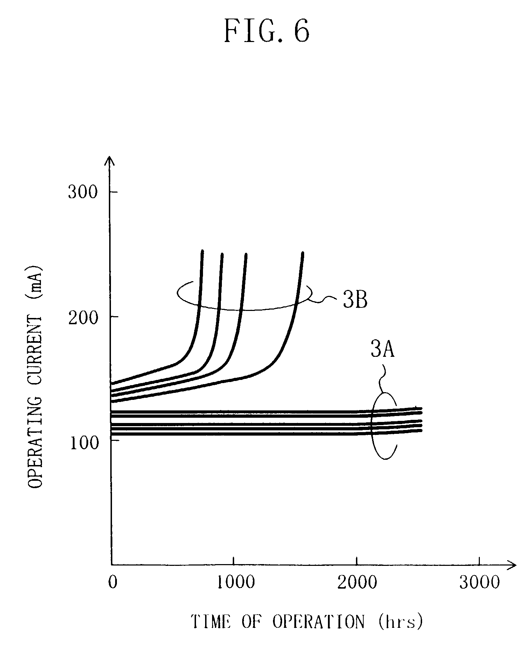

FIG. **6** is a graph illustrating results of a high-temperature continuity test that was carried out on semiconductor laser diodes according to the first embodiment and the first prior art example.

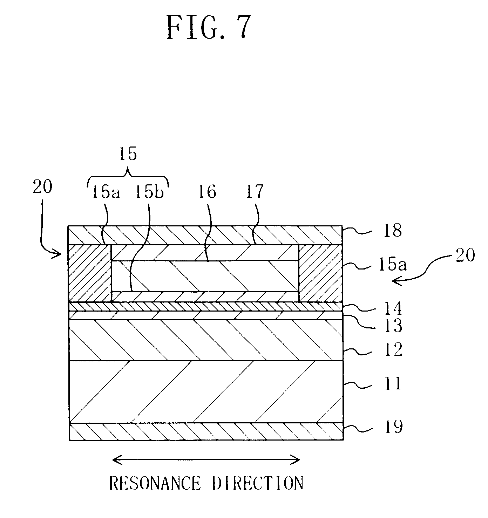

FIG. **7** is a cross-sectional view, taken in the resonance direction, illustrating a structure for a semiconductor laser diode according to a modified example of the first embodiment.

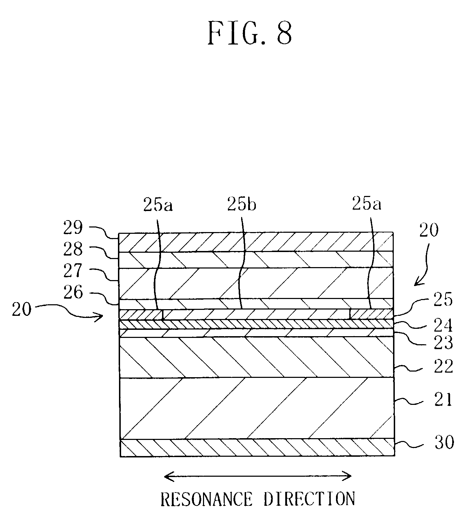

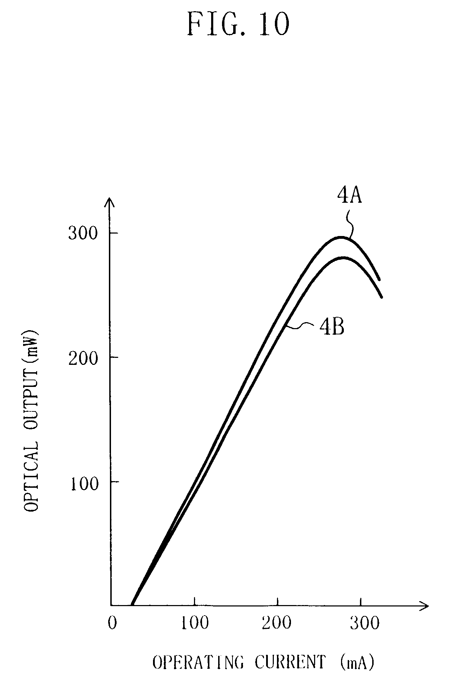

FIG. **8** is a cross-sectional view, taken in the resonance direction, illustrating a structure for a semiconductor laser diode according to a second embodiment of the present invention.

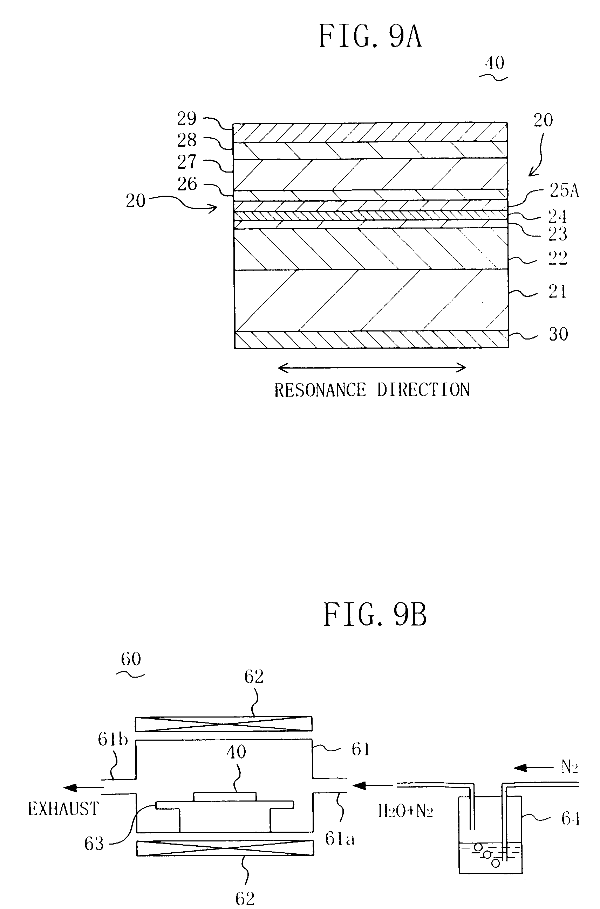

FIGS. **9A** and **9B** are cross-sectional views illustrating respective process steps for fabricating the semiconductor laser diode of the second embodiment.

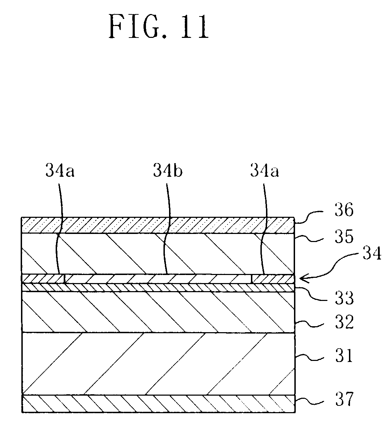

FIG. **10** is a graph illustrating the current-optical output power characteristics of the semiconductor laser diodes of the first and second embodiments in comparison.

FIG. **11** is a cross-sectional view illustrating a structure for a light-emitting diode according to a third embodiment of the present invention.

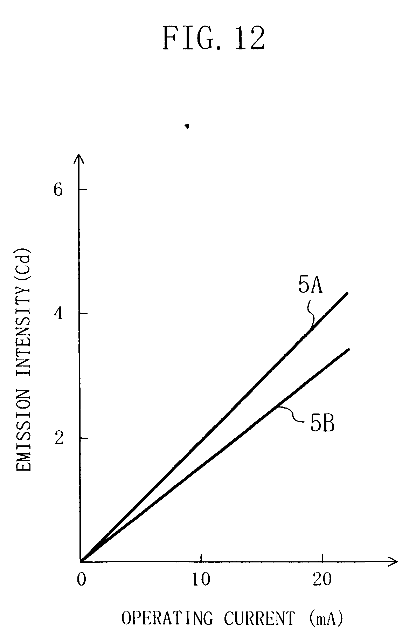

FIG. **12** is a graph illustrating the current-emission intensity characteristics of light-emitting diodes according to the third embodiment and a prior art example in comparison.

FIG. **13** is a cross-sectional view, taken in the resonance direction, illustrating a structure for a semiconductor laser diode according to the first prior art example.

FIGS. **14A** and **14B** are band diagrams illustrating the distributions of bandgaps in a semiconductor laser diode of the first prior art example:
FIG. **14A** illustrates energy levels for a non-Zn-diffused region; and
FIG. **14B** illustrates energy levels for a Zn-diffused region.

### DESCRIPTION OF THE PREFERRED EMBODIMENTS

### EMBODIMENT 1

Hereinafter, a first embodiment of the present invention will be described with reference to the accompanying drawings.

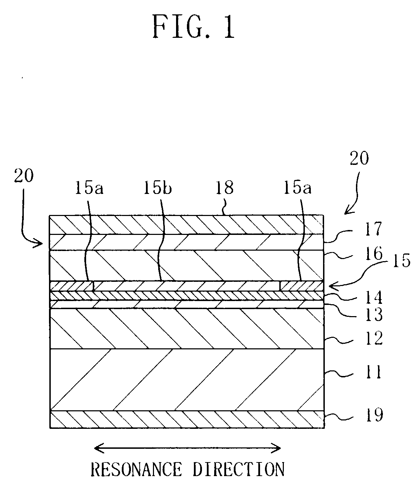

FIG. **1** illustrates a cross-sectional structure for a semiconductor laser diode according to the first embodiment. The cross section illustrated in FIG. **1** is taken in the resonance direction.

As shown in FIG. **1**, an epitaxial structure is formed on a substrate **11** of n-GaAs, for example. The structure includes first cladding layer **12**, first optical guide layer **13**, quantum well active layer **14,** second optical guide layer **15**, second cladding layer **16** and contact layer **17** that have been stacked in this order. The first cladding layer **12** is made of n-Al_{0.5}Ga_{0.5}As and has a thickness of about 1.5µm. The first optical guide layer **13** is made of undoped Al_{0.3}Ga_{0.7}As and has a thickness of about 20 nm. The active layer **14** is made of undoped GaAs and has a thickness of about 5 nm. The second optical guide layer **15** is made of undoped AlGaAs and has a thickness of about 20 nm. The second cladding layer **16** is made of p-Al_{0.5}Ga_{0.5}As. And the contact layer **17** is made of p-GaAs. It should be noted that the quantum well active layer **14** may also be made of AlGaAs with an Al mole fraction of 0.3 or less.

A p-side electrode **18** is formed on the contact layer **17** by stacking chromium (Cr), platinum (Pt) and gold (Au) layers, for example, in this order thereon. On the backside of the substrate **11**, i.e., on the opposite side to the p-side electrode **18**, an n-side electrode **19** is formed by stacking an alloy layer containing Au, germanium (Ge) and nickel (Ni), for example, and an Au layer in this order thereon.

The facets **20** of the epitaxial structure, which are located at both ends of the resonant cavity as defined in the resonance direction, are formed to be substantially vertical to the principal surface of the substrate 11 and to be parallel to each other.

The first embodiment is characterized in that part of the second optical guide layer **15**, formed on the active layer **14**, has an Al mole fraction different from that of the other parts thereof. And these two types of parts with mutually different Al mole fractions are adjacent to each other in the resonance direction. Specifically, parts of the second optical guide layer **15**, extending from the facets **20** inward over a distance of about 10µm each, are parts **15a** with a high Al mole fraction of about 0.7 (which will be herein called "Al-rich parts"). The other part of the second optical guide layer **15** interposed between these parts **15a** is a part **15b** with a low Al mole fraction of about 0.3 (which will be herein called a "non-Al-rich part"). In this case, the second optical guide layer **15** functions as a barrier layer that confines electrons, holes and recombined radiation (i.e., recombined electron-hole pairs) in the quantum well active layer **14**.

The second optical guide layer **15** includes the Al-rich parts **15a** near both facets **20** of the resonant cavity. Thus, the bandgap of the Al-rich parts **15a** is greater than that of the non-Al-rich part **15b**. As a result, the first quantum level (i.e., the ground-state quantum level) in parts of the active layer **14** around the edges **20** of the resonant cavity becomes higher than that in the other part of the active layer **14** under the non-Al-rich part **15b**.

FIGS. **2A** and **2B** illustrate this quantum level shifting.

FIGS. **2A** and **2B** are band diagrams illustrating energy levels of the quantum well active layer **14** and its neighbors in the semiconductor laser diode of the first embodiment. FIG. **2A** illustrates energy levels for the inner part of the resonant cavity including the non-Al-rich part **15b**. FIG. **2B** illustrates energy levels for the outer parts of the resonant cavity including the Al-rich parts **15a**.

As shown in FIG. **2A**, the quantum well has a horizontally symmetric structure in the region including the non-Al-rich part **15b.** In this case, the energy required for electrons and holes to make transitions between the first quantum levels is 1.529 eV, which is equivalent to an oscillation wavelength of 811 nm for laser radiation.

On the other hand, the quantum well shown in FIG. **2B** has an asymmetric structure in the regions including the Al-rich parts **15a** located around the facets **20** of the resonant cavity. In this quantum well structure, the bandgap of the Al-rich part **15a** is greater than that of the first optical guide layer **13**. In this case, the energy required for transition between the first quantum levels is 1.548 eV, which is equivalent to an oscillation wavelength of 801 nm for laser radiation. In this manner, high-quantum-level regions **10** have been created because the first quantum level has risen to a higher energy level around the facets **20** of the resonant cavity.

Next, the emission spectra of the Al-rich and non-Al-rich parts **15a** and **15b** will be analyzed.

FIG. **3** illustrates the spectra of radiation emitted from respective parts of the quantum well active layer **14** under the Al-rich and non-Al-rich parts **15a** and **15b**, respectively, in the laser diode of the first embodiment. The spectra illustrated in FIG. **3** were measured by a photoluminescence spectroscopy. In FIG. **3**, the abscissa indicates the wavelength, while the ordinate indicates the photoluminescence intensity at an arbitrary unit.

As shown in FIG. **3**, the peak of the emission spectrum **1A** corresponding to the Al-rich-parts **15a** has shifted (i.e., decreased) from that of the emission spectrum **1B** corresponding to the non-Al-rich part **15b** by about 10 nm.

In this manner, those parts of the quantum well active layer **14**, which are located under the Al-rich parts **15a**, have their absorption coefficient decreased considerably. That is to say, the laser radiation, created in the active layer **14,** is much less likely to be absorbed into the resonant cavity around the facets **20** thereof, thus suppressing the COD phenomenon. As a result, the semiconductor laser diode can have its threshold current density decreased and have its slope efficiency and maximum optical output power both increased.

According to the first embodiment, the Al-rich and non-Al-rich parts **15a** and **15b** are defined along a plane of the second optical guide layer **15** and the quantum well active layer **14**, located under the second optical guide layer **15**, is not altered in any way. Thus, no damage is done on the active layer **14.** That is to say, since the crystallinity of the active layer **14** does not deteriorate, the loss does not increase or the reliability does not degrade, either.

In the first embodiment, the Al-rich and non-Al-rich parts **15a** and **15b** are formed in the second optical guide layer **15**. Alternatively, these parts may be defined in the first optical guide layer **13** located under the active layer **14**. And if necessary, these parts may be provided for both the first and second optical guide layers **13** and **15**.

Furthermore, the quantum well active layer **14** is made of GaAs in the foregoing embodiment. Optionally, the active layer **14** may contain aluminum so long as the Al mole fraction of the active layer **14** is smaller than that of the first or second optical guide layer **13** or **15**.

Hereinafter, a method for fabricating a semiconductor laser diode with such a structure will be described with reference to FIGS. **4A** through **4C**.

FIGS. **4A** through **4C** illustrate cross-sectional structures corresponding to respective process steps for fabricating the semiconductor laser diode of the first embodiment.

First, as shown in FIG. **4A**, the first cladding layer **12**, first optical guide layer **13**, quantum well active layer **14**, second optical guide layer prototype **15A**, second cladding layer prototype **16A** and contact layer prototype **17A** are formed in this order on the n-GaAs substrate **11** by a metalorganic vapor phase epitaxy (MOVPE) process, for example. In this process step, the second optical guide layer prototype **15A** is made of p-Al_{0.3}Ga_{0.7}As. In this manner, an epitaxial substrate is prepared.

Next, as shown in FIG. **4B**, a mask pattern **50** having an opening with a width of about 20µm as measured in the resonance direction is defined by photolithography on the epitaxial substrate. And the substrate is dry-etched using the pattern **50** as a mask until the active layer **14** is partially exposed. In this manner, non-Al-rich parts **15b** are formed out of the second optical guide layer prototype **15A**.

Then, as shown in FIG. **4C**, an MOCVD process is performed to grow respective crystals again with the mask pattern **50** left, thereby forming Al-rich parts **15a** of p-Al_{0.7}Ga_{0.3}As, second cladding layer **16** and contact layer **17**. Subsequently, the mask pattern **20** is removed and then p- and n-side electrodes **18** and **19** are formed on the contact layer **17** and on the backside of the substrate **11**, respectively. Thereafter, the Al-rich part **15a**, interposed between the non-Al-rich parts **15b**, is cleaved at the center, thereby defining the facets **20** of the resonant cavity. In this manner, the semiconductor laser diode shown in FIG. **1** is completed.

Thus, according to the fabrication process of the first embodiment, the quantum well active layer **14** is not etched and most of the active layer **14** (i.e., parts of the layer **14** under the non-Al-rich parts **15b**) is not exposed to the etching gas. That is to say, no etching damage is done on the active layer **14**. Accordingly, the deterioration in performance of the semiconductor laser diode with time can be reduced considerably.

Next, the performance of the semiconductor laser diode according to the first embodiment will be described.

FIG. **5** illustrates the current-optical output power characteristics of semiconductor laser diodes according to the first embodiment and the first prior art example in comparison. In FIG. **5**, the abscissa indicates the operating current, while the ordinate indicates the optical output power. The characteristics of the laser diodes of the first embodiment and the first prior art example are represented by the curves **2A** and **2B**, respectively.

As can be seen from FIG. **5**, the laser diode of the first embodiment has a threshold current value smaller than that of the diode of the first prior art example. In addition, the slope efficiency and maximum optical output power of the diode of the first embodiment are both greater than those of the first prior art example. Specifically, the maximum output power of the diode of the first embodiment is 1.5 time higher than that of the diode of the first prior art example.

FIG. **6** illustrates results of a high-temperature continuity test that was carried out on the semiconductor laser diodes of the first embodiment and the first prior art example. In FIG. **6**, the abscissa indicates the time of operation, while the ordinate indicates the operating current. In this case, these diodes were made to continuously oscillate under the conditions that the operating temperature was 60°C and the optical output power was kept constant at 100 mW. The characteristics of the laser diodes of the first embodiment and the first prior art example are represented by the two sets **3A** and **3B** of curves, respectively.

As can be seen from FIG. **6**, the operating current of the laser diode of the first prior art example steeply rose when the diode was operated for about 1,000 hours. In contrast, even after the laser diode of the first embodiment had been operated for more than 2,000 hours, the operating current thereof was substantially constant. Thus, it can be seen that the diode of the first embodiment can operate much more reliably than the diode of the first prior art example.

It should be noted that the same effects are attainable even if the Al-rich parts **15a** of the second optical guide layer **15** are grown to the top of the epitaxial structure as shown in FIG. **7**.

In the foregoing embodiment, the Al-rich parts **15a**, which create the high-quantum-level regions **10** in the quantum well active layer **14**, are formed on the active layer **14**. Optionally, one or more semiconductor layers may be interposed between the Al-rich parts **15a** and the active layer **14**. In that case, the effects of this embodiment are also attainable so long as the total thickness of the additional semiconductor layers is smaller than the amplitude of the wave function of electrons or holes confined in the quantum well active layer 14.

### EMBODIMENT 2

Hereinafter, a second embodiment of the present invention will be described with reference to the accompanying drawings.

FIG. **8** illustrates a cross-sectional structure for a semiconductor laser diode according to the second embodiment. The cross section illustrated in FIG. **8** is taken in the resonance direction.

As shown in FIG. **8**, an epitaxial structure is formed on a substrate **21** of n-GaAs, for example. The structure includes first cladding layer **22**, first optical guide layer **23**, quantum well active layer **24**, barrier layer **25**, second optical guide layer **26**, second cladding layer **27** and contact layer **28** that have been stacked in this order. The first cladding layer **22** is made of n-Al_{0.5}Ga_{0.5}As and has a thickness of about 1.5µm. The first optical guide layer **23** is made of undoped Al_{0.3}Ga_{0.7}As and has a thickness of about 20 nm. The active layer **24** is made of undoped GaAs and has a thickness of about 5 nm. The barrier layer **25** contains aluminum and arsenic and has a thickness of about 2 nm. The second optical guide layer **26** is made of undoped Al_{0.3}Ga_{0.7}As and has a thickness of about 20 nm. The second cladding layer **27** is made of p-Al_{0.5}Ga_{0.5}As. And the contact layer **28** is made of p-GaAs.

A p-side electrode **29** is formed on the contact layer **28** by stacking Cr, Pt and Au layers, for example, in this order thereon. On the backside of the substrate **21**, i.e., on the opposite side to the p-side electrode **29**, an n-side electrode **30** is formed by stacking an alloy layer containing Au, Ge and Ni, for example, and an Au layer in this order thereon.

The facets **20** of the epitaxial structure, which are located at both ends of the resonant cavity as defined in the resonance direction, are formed to be substantially vertical to the principal surface of the substrate **21** and to be parallel to each other.

The second embodiment is characterized in that part of the barrier layer **25**, interposed between the quantum well active layer **24** and second optical guide layer **26**, has a composition different from that of the other parts thereof. And these two types of parts with mutually different compositions are adjacent to each other in the resonance direction. Specifically, parts of the barrier layer **25**, which extend from the facets **20** inward over a distance of about 10µm each, are oxidized parts **25a** made of aluminum arsenide oxide (i.e., AlₓAs_{y}O_{1-x-y}, where 0<x<1, 0<y< 1 and 0<x+y<1). The other part of the barrier layer **25** interposed between these oxidized parts **25a** is a non-oxidized part **25b** made of aluminum arsenide (AlAs).

The barrier layer **25** includes the oxidized parts **25a** near both facets **20** of the resonant cavity. Thus, the bandgap of the oxidized parts **25a** is greater than that of the non-oxidized part **25b**. As a result, the first quantum level (i.e., the ground-state quantum level) in parts of the active layer **24** around the facets **20** of the resonant cavity becomes higher than that in the other part of the active layer **24** under the non-oxidized part **25b**. Accordingly, those parts of the active layer **24**, located under the oxidized parts **25a**, have their absorption coefficient decreased considerably. That is to say, the laser radiation, created in the active layer **24**, is much less likely to be absorbed into the resonant cavity around the facets **20** thereof, thus suppressing the COD phenomenon. As a result, the semiconductor laser diode can have its threshold current density decreased and have its slope efficiency and maximum optical output power both increased.

Hereinafter, a method for fabricating a semiconductor laser diode with such a structure will be described with reference to FIGS. **9A** and **9B**.

First, as shown in FIG. **9A**, the first cladding layer **22**, first optical guide layer **23**, quantum well active layer **24**, barrier layer prototype **25A** of AlAs, second optical guide layer **26**, second cladding layer **27** and contact layer **28** are formed in this order on the n-GaAs substrate **21** by an MOVPE process, for example. In this manner, an epitaxial substrate **40** is prepared. Thereafter, the p- and n-side electrodes **29** and **30** are formed on the contact layer **28** and on the backside of the substrate **21**, respectively. Thereafter, the epitaxial substrate **40** is cleaved at a predetermined position, thereby defining the facets **20** of the resonant cavity.

Next, as shown in FIG. **9B**, the cleaved epitaxial substrate **40** is oxidized using an electric furnace **60** within a water vapor ambient.

The electric furnace **60** includes a reaction tube **61** of quartz and a heater **62** that surrounds the tube **61**. The tube **61** has gas inlet and outlet ports **61a** and **61b**. A substrate holder **63** is placed inside the tube **61**.

Using this electric furnace **60**, the oxidation process may be performed with the epitaxial substrate **40**, which is held on the holder **63** and heated to about 300°C or more, exposed to a mixture of water vapor (H₂O) and nitrogen (N₂) gas. The mixture is produced by externally blowing the nitrogen gas against the water stored in a tank **64**. Also, by adjusting the heating temperature, the oxidation rate of the barrier layer prototype **25A** is controllable. The pressure inside the tube **61** is atmospheric pressure.

In this manner, oxygen atoms in the state of water vapor are introduced through the facets **20** of the resonant cavity into the epitaxial substrate **40**, thereby selectively oxidizing the barrier layer prototype **25A**. As a result, the oxidized parts **25a** of aluminum arsenide oxide are formed at the edges of the barrier layer prototype **25A**.

As can be seen, the AlAs barrier layer prototype **25A**, formed on the quantum well active layer **24**, reacts with oxygen very easily. Thus, the edges of the barrier layer prototype **25A** can be oxidized selectively almost without oxidizing the quantum well active layer **24**. As a result, the oxidized parts **25a** can be formed at the edges of the barrier layer prototype **25A** just as intended.

Hereinafter, the performance of the semiconductor laser diode according to the second embodiment will be described.

First, the difference in bandgap between the oxidized and non-oxidized parts **25a** and **25b** as identified by a photoluminescence spectroscopy will be described.

The peak wavelengths of photoluminescence emission spectra of the AlₓAs_{y}O_{1-x-y} oxidized parts **25a** and AlAs non-oxidized part **25b** measured about 760 nm and 797 nm, respectively, according to the results of experiments carried by the present inventors. Thus, it can be seen that the peak wavelength of the oxidized parts **25a** shifted (or decreased) from that of the non-oxidized part **25b** and that the oxidized parts **25a** should have a bandgap greater than that of the non-oxidized part **25b**.

Next, the current-optical output power characteristic of the semiconductor laser diode of the second embodiment will be described.

FIG. **10** illustrates the current-optical output power characteristics of semiconductor laser diodes according to the first and second embodiments in comparison. In FIG. **10**, the abscissa indicates the operating current, while the ordinate indicates the optical output power. The characteristics of the laser diodes of the first and second embodiments are represented by the curves **4B** and **4A**, respectively.

As can be seen from FIG. **10**, the laser diode of the second embodiment has a threshold current value slightly smaller than that of the diode of the first embodiment. In addition, the slope efficiency and maximum optical output power of the diode of the second embodiment are both greater than those of the first embodiment. This is because AlₓAs_{y}O_{1-x-y} for the oxidized parts **25a** has so high insulation properties that the amount of idle current flowing through the oxidized parts 25a is much smaller.

In the second embodiment, the quantum well active layer **24** is made of GaAs. However, the same effects are attainable even if the active layer **24** is made of AlGaAs with a small Al mole fraction. Where Al is contained, the Al mole fraction should be about 0.3 or less, because the luminous efficacy can be particularly increased in that case.

The thickness of the barrier layer **25** is preferably from 0.5 nm through 20 nm. The reason is as follows. If the thickness of the barrier layer **25** is 0.5 nm or more, then part of the active layer **24** with a thickness representing the wave function of electrons and holes in the active layer **24** does not expand deeper into the second optical guide layer **26**. As a result, the rise in quantum energy level of the active layer **24**, which has been caused due to the increased bandgap of the barrier layer **25**, is promoted.

On the other hand, if the thickness of the barrier layer **25** is 20 nm or less, then a good number of carriers are injected from the second optical guide layer **26** into the active layer **24**. As a result, the operating voltage of the semiconductor laser diode decreases.

Also, the barrier layer **25**, which is interposed between the active layer **24** and the p-type second cladding layer **27**, may be undoped but is preferably doped with a p-type dopant. In that case, holes can be injected into the active layer **24** even more efficiently.

In the second embodiment, the AlAs barrier layer **25** is formed between the active layer **24** and the second optical guide layer **26**. Alternatively, the AlAs barrier layer may be provided between the active layer **24** and the first optical guide layer **23**. As another alternative, the AlAs barrier layers may be formed under and over the active layer **24**. Where the barrier layer is formed on the n-type first optical guide layer **23**, the barrier layer may be undoped but is preferably doped with an n-type dopant. This is because electrons can be injected into the active layer **24** even more efficiently in that case.

Furthermore, in the second embodiment, the oxidized parts **25a**, which create the high-quantum-level regions in the quantum well active layer **24**, are defined on the active layer **24**. Optionally, one or more semiconductor layers may be interposed between the oxidized parts **25a** and the active layer **24**. In that case, the effects of this embodiment are also attainable so long as the total thickness of the additional semiconductor layers is smaller than the amplitude of the wave function of electrons or holes confined in the quantum well active layer **24**.

### EMBODIMENT 3

Hereinafter, a third embodiment of the present invention will be described with reference to the accompanying drawings.

FIG. **11** illustrates a cross-sectional structure for a light-emitting diode according to a third embodiment of the present invention.

As shown in FIG. **11**, first cladding layer **32**, quantum well active layer **33**, barrier layer **34** and second cladding layer **35** are stacked in this order on a substrate **31** of n-GaAs. The first cladding layer **32** is made of n-AlGaInP and has a thickness of about 1µm. The active layer **33** is made of undoped InGaP and has a thickness of about 5 nm. The barrier layer **34** contains AlInP and has a thickness of about 2 nm. The second cladding layer **35** is made of p-AlGaInP.

A p-side electrode **36**, which is transparent to the radiation emitted, is formed on the second cladding layer **35**. On the backside of the substrate **31**, i.e., on the opposite side to the p-side electrode **36**, an n-side electrode **37** is formed by stacking an alloy layer containing Au, Ge and Ni, for example, and an Au layer in this order thereon.

The third embodiment is characterized in that part of the barrier layer **34**, interposed between the quantum well active layer **33** and second cladding layer **35**, has a composition different from that of the other parts thereof. And these two types of parts with mutually different compositions are adjacent to each other within a plane. Specifically, parts of the barrier layer **34**, which extend from the side faces inward over a distance of about 10µm each, are oxidized parts **34a** made of a compound of AlInP and oxygen. The other part of the barrier layer **34** interposed between these oxidized parts **34a** is a non-oxidized part **34b** made of AlInP.

The barrier layer **34** includes the oxidized parts **34a** around the side faces thereof. Thus, the bandgap of the oxidized parts **34a** is greater than that of the non-oxidized part **34b**. As a result, the amount of the operating current, flowing into the oxidized parts **34a** can be reduced. That is to say, it is possible to reduce the amount of current injected into those parts of the active layer **33** around the side faces thereof, where centers of non-radiative recombination, not contributing to the emission, exist in great numbers. Accordingly, the light-emitting diode can have its luminous efficacy increased.

The light-emitting diode of the third embodiment may be fabricated as in the second embodiment. Specifically, first, the respective semiconductor layers are grown epitaxially. Next, the p- and n-side electrodes **36** and **37** are formed. Then, the substrate is cleaved to a predetermined size. And then the cleaved end faces are annealed and oxidized within a water vapor ambient. By performing this oxidation process, the oxidized parts **34a**, extending from the cleaved end faces of the barrier layer **34** inward, are formed out of a compound of AlInP and oxygen.

In this process step, AlInP, which reacts with oxygen very easily, is oxidized selectively. Accordingly, the active layer **33** of InGaP is hardly oxidized and only those parts of the barrier layer **34** around the end faces can be oxidized selectively. As a result, the quantum well active layer **33** can exhibit good emission characteristics. In this case, the active layer **33** may be made of Gap, not InGaP.

It should be noted that the barrier layer **34** may be oxidized selectively by a mixture of oxygen plasma and hydrogen instead of water vapor.

Hereinafter, the performance of the light-emitting diode of the third embodiment will be described.

First, the difference in bandgap between the oxidized and non-oxidized parts **34a** and **34b** as identified by a photoluminescence spectroscopy will be described.

The peak wavelengths of photoluminescence emission spectra of the oxidized parts **34a** and non-oxidized part **34b** measured about 600 nm and 630 nm, respectively, according to the results of experiments carried by the present inventors. Thus, it can be seen that the peak wavelength of the oxidized parts **34a** shifted (or decreased) from that of the non-oxidized part **34b** and that the oxidized parts **34a** should have a bandgap greater than that of the non-oxidized part **34b**.

Next, the current-emission intensity characteristic of the light-emitting diode of the third embodiment will be described.

FIG. **12** illustrates the current-emission intensity characteristics of a light-emitting diode according to the third embodiment with the oxidized parts **34a** and a known light-emitting diode with no oxidized parts **34a** in comparison. In FIG. **10**, the abscissa indicates the operating current, while the ordinate indicates the emission intensity. The characteristics of the light-emitting diodes of the third embodiment and the prior art are represented by the curves **5A** and **5B**, respectively.

As can be seen from FIG. **12**, the light-emitting diode of the third embodiment has an emission intensity greater than that of the known diode by about 10%. This is because interfacial levels are created around the cleaved end faces of the active layer **33** due to the exposure of the faces to the air. As a result, centers of non-radiative recombination are formed around the end faces of the active layer **33** so that the luminous efficacy decreases near the facets.

The light-emitting diode of the third embodiment includes the oxidized parts **34a** with a bandgap greater than that of the inner part **34b** around the side edges of the barrier layer **34**. Thus, a larger part of the current injected flows through the non-oxidized part **34b** than the oxidized parts **34a** located around the side edges. That is to say, a greater amount of current flows through the non-oxidized part **34b** exhibiting a higher luminous efficacy. As a result, the light-emitting diode can have its luminous efficacy increased.

In the third embodiment, the AlInP barrier layer **34** is formed between the active layer **33** and the second cladding layer **35**. Alternatively, the AlInP barrier layer may be provided only between the active layer **33** and the first cladding layer **32**. As another alternative, the InGaP barrier layers may be formed under and over the active layer **33**. Where the barrier layer is formed on the n-type first cladding layer **32**, the barrier layer may be undoped but is preferably doped with an n-type dopant. This is because electrons can be injected into the active layer **33** even more efficiently in that case.

Furthermore, in the third embodiment, the oxidized parts 34a, which create the high-quantum-level regions in the quantum well active layer **33**, are defined on the active layer **33**. Optionally, one or more semiconductor layers may be interposed between the oxidized parts **34a** and the active layer **33**. In that case, the effects of this embodiment are also attainable so long as the total thickness of the additional semiconductor layers is smaller than the amplitude of the wave function of electrons or holes confined in the active layer **33**.

In the foregoing embodiments, the active layer for creating radiation to be emitted has a single quantum well structure. Alternatively, the active layer may have a multi-quantum well (MQW) structure having multiple quantum wells.

If the MQW structure is applied to the first embodiment, each of the barrier layers in the MQW structure should be thin enough to allow electrons to be combined between the quantum wells. That is to say, the MQW structure is preferably of a combination type.

On the other hand, if the MQW structure is applied to the second or third embodiment, the bandgap at the edges of a barrier layer, adjacent to each quantum well layer, should be greater than the inner part of the barrier layer.

Also, in the foregoing embodiments, the Al-rich parts or oxidized parts, which create the high-quantum-level regions, are formed at both ends. Alternatively, only one such part may be provided at either end.

Furthermore, in the foregoing embodiments, the semiconductor layers are made of AlGaAs or AlGaInP. However, these layers may also be made of a Group III nitride semiconductor that can emit radiation at an even shorter wavelength, i.e., BₓAl_{y}Ga_{1-x-y-z}In_{z}N, where 0≦x≦1, 0≦y≦1, 0≦z≦1 and 0≦x+y+z≦ 1.

## Claims

1. A semiconductor light emitter comprising:
a first semiconductor layer formed over a substrate;
a second semiconductor layer formed over the first layer; and
a third semiconductor layer formed over the second layer,
wherein bandgaps of the first and third layers are greater than a bandgap of the second layer, and
wherein a high-quantum-level region is defined around an edge of the second layer, the first quantum level being higher in the high-quantum-level region than in the other regions of the second layer.

2. The emitter of Claim 1, wherein parts of the first or third layer, which are located near the edges of the second layer, have a bandgap greater than the other part of the first or third layer.

3. The emitter of Claim 1, wherein the first layer has a pair of facets that extend substantially vertically to the principal surface of the substrate and that face each other, and
wherein at least one of these facets is located in the high-quantum-level region.

4. The emitter of Claim 1, wherein each said high-quantum-level region is defined to extend from an associated facet of the second layer inward over a predetermined distance.

5. The emitter of Claim 1, wherein the first or third layer has a thickness of 0.5 nm through 20 nm.

6. The emitter of Claim 1, wherein the first or third layer is made of a semiconductor that reacts with oxygen atoms more easily than the second layer does, and
wherein oxygen atoms have been introduced into edges of the first or third layer to a level higher than the other part of the first or third layer so that a bandgap at the edges of the first or third layer is greater than a bandgap in the other part of the first or third layer.

7. The emitter of Claim 1, wherein the first and third layers are made of AlGaAs, and
wherein the second layer is made of: AlGaAs that has an Al mole fraction smaller than that of AlGaAs for the first and third layers; InGaAs; or GaAs.

8. The emitter of Claim 7, wherein the Al mole fraction in the second layer is 0.3 or less.

9. The emitter of Claim 1, wherein the first and third layers are made of AlGaInP, and
wherein the second layer is made of: AlGaInP that has an Al mole fraction smaller than that of AlGaInP for the first and third layers; InGaP; or GaAs.

10. The emitter of Claim 9, wherein the Al mole fraction in the second layer is 0.3 or less.

11. The emitter of Claim 1, wherein the first and third layers are made of BₓAl_{y}Ga_{1-x-y-z}In_{z}N, where 0≦x≦1, 0≦y≦1, 0≦z ≦1 and 0≦x+y+z≦1, and
wherein the second layer is made of: BₓAl_{y}Ga_{1-x-y-z}In_{z}N, where 0≦x≦1, 0≦y≦1, 0≦z≦1 and 0≦x+y+z≦1 and which has an Al mole fraction smaller than that of BₓAl_{y}Ga_{1-x-y-z}In_{z}N for the first and third layers; InGaN; or GaN.

12. The emitter of Claim 1, wherein the second layer comprises a quantum well layer.

13. A semiconductor light emitter comprising:
a first semiconductor layer formed over a substrate;
a second semiconductor layer formed over the first layer; and
a third semiconductor layer formed over the second layer,
wherein the first or third layer has a bandgap greater than a bandgap of the second layer and is made of a semiconductor that reacts with oxygen atoms more easily than the second layer does, and
wherein oxygen atoms have been introduced into edges of the first or third layer to a level higher than the other part of the first or third layer so that a bandgap at the edges of the first or third layer is greater than a bandgap in the other part of the first or third layer.

14. The emitter of Claim 13, wherein the second layer comprises a quantum well layer.

15. A method for fabricating a semiconductor light emitter, comprising the steps of:
a) stacking first, second and third semiconductor layers in this order over a substrate to obtain a multilayer structure including the first, second and third layers; and
b) exposing at least one side face of the multilayer structure to an ambient containing oxygen atoms, thereby oxidizing a side face of the first or second layer.

16. The method of Claim 15, wherein the first and third layers have a bandgap greater than that of the second layer.

17. The method of Claim 15, wherein the first or third layer is made of a semiconductor that reacts with oxygen atoms more easily than the second layer does.

18. The method of Claim 15, wherein the step a) comprises the step of forming a quantum well layer in the second layer.

19. The method of Claim 15, wherein the step b) comprises an annealing process in which water vapor is used as the ambient.
